# EUROPEAN PATENT SPECIFICATION

(11) **EP 0 782 141 B1**
(45) Date of publication and mention of the grant of the patent: **19.03.2003**
(21) Application number: 96309400.8
(22) Date of filing: 23.12.1996
(51) Int. Cl.: G11C 5/14, G11C 11/407

(54) **Voltage pumping circuit for semiconductor memory device**
Spannungspumpenschaltung für Halbleiterspeicheranordnung
Circuit de pompage de tension pour dispositif de mémoire à semi-conducteurs

(30) Priority: 27.12.1995 KR 5941495
(43) Date of publication of application: 02.07.1997
(73) Proprietor: Samsung Electronics Co., Ltd., Suwon City, Kyungki-do (KR)
(72) Inventor: Bae, Yong-Cheol, Ohgeum-dong,Songpa-gu, Seoul (KR); Yoon, Sei-Seung, Yongsan-gu. Seoul (KR); Seo, Dong-Il, Paldal-gu, Suwon-city,Kyungki-do (KR)
(74) Representative: Tunstall, Christopher Stephen

(56) References cited:
- GB-A- 2 296 986
- GB-A- 2 306 718
- US-A- 4 769 792
- US-A- 5 267 214

## Description

### Background to the Invention

The present invention relates to voltage pumping circuits for semiconductor memory devices.

Generally, a voltage pumping circuit is provided in a semiconductor memory device to generate a pumped voltage which is higher in level than an operating voltage in the memory device. For example, the pumped voltage from the voltage pumping circuit may be used as a word line voltage which is supplied to a word line and an isolation gate control signal which is transferred to isolation gates in a charge sharing sense amplifier configuration. The voltage pumping circuit typically comprises two parts, a main pump and an active kicker. In the voltage pumping circuit, only the main pump is operated in the standby mode and both the main pump and active kicker are operated in an active mode to supply a large amount of charge.

Recently, semiconductor memory devices comprising banks have been developed which perform bank operations. The arrangement of voltage pumping circuits is important in such semiconductor memory devices as perform bank operations. In other words, because voltage pumping circuits include large-capacity capacitors, their number and position have an important effect on chip size. In a conventional memory device with no bank operation, voltage pumping circuits must be provided to supply sufficiently pumped voltages to word lines which are simultaneously enabled and additional voltage pumping circuits must be provided to supply pumped voltages to other elements.

US 5,267,214 describes a DRAM memory having a memory array split into several blocks, adjacent blocks sharing banks of sense amplifiers. A control circuit is provided for selectively enabling the sense amplifiers. US 5,339,279 describes a block erasable flash EEPROM memory, having a charge pump allocated to each block, wherein each charge pump has a capacitor sized in proportion to the size of the associated block. US 4,769,792 describes a circuit for continuously supplying an increased bootstrap voltage to a row or column decoder, by cyclically enabling one of two or more voltage bootstrap circuits.

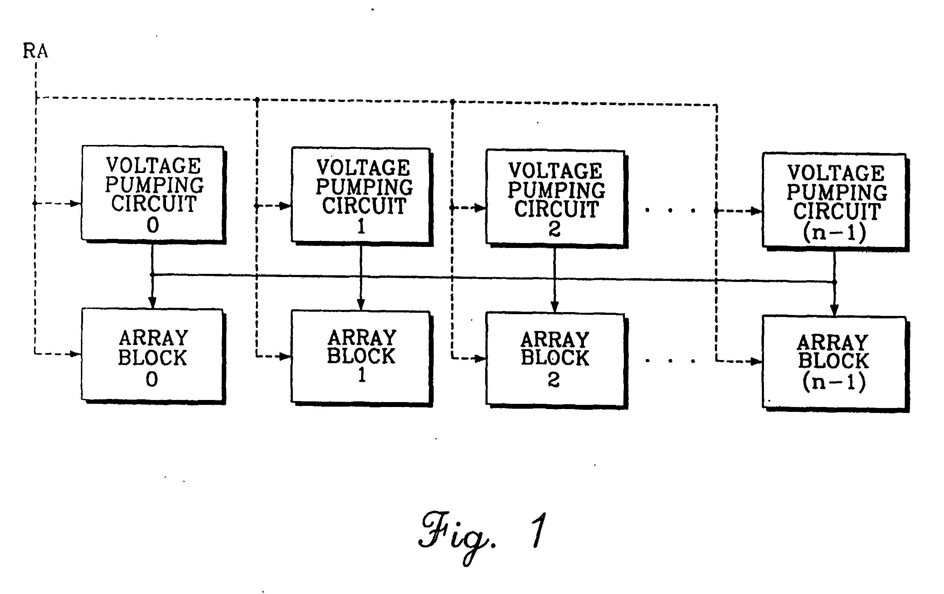

FIG. 1 is a block diagram illustrating a conventional layout of array blocks and voltage pumping circuits in a semiconductor memory device. As shown in this drawing, when a row address signal is applied, word lines in the array blocks corresponding to the applied row address signal are simultaneously enabled. The voltage pumping circuits are operated to supply word line voltages of pumped levels to the enabled word lines.

However, in a semiconductor memory device performing a bank operation, such as a synchronous memory, banks are provided in such a manner that a selected bank can be made active in response to bank selection information of the row address signal.

The present invention has as it objective to provide a semiconductor memory device in which voltage pumping circuits are arranged in a semiconductor memory device using bank selection in a proper manner to reduce chip size.

### Summary of the Invention

In accordance with the present invention, A semiconductor memory device comprises:
a memory cell array including a number, n, of banks, where n > 2;
a number, m, of voltage pumping circuits each for pumping an input voltage to a desired level (Vpp), where 2 ≤ m < n;
a control circuit adapted to receive address signals selecting respective banks and, in response, to activate a selected voltage pumping circuit;
**characterised in that** the control circuit is adapted, on receipt of any address signal selecting any one of the n banks, to activate the next in a predetermined cyclic sequence of the m voltage pumping circuits.

The present invention also extends to a method of operating a semiconductor memory device comprising a memory cell array including a number, n, of banks, where n > 2 and a number, m, of voltage pumping circuits each for pumping an input voltage to a desired level (Vpp), where 2 < m < n, the method comprising:
receiving address signals selecting respective banks and, in response, activating a selected voltage pumping circuit;
**characterised in that**, on receipt of any address signal selecting any one of the n banks, the next in a predetermined cyclic sequence of the m voltage pumping circuits is activated.

### Brief Description of the Drawings

The present invention will now be described by way of example with reference to the accompanying drawings in which:
FIG. 1 is a block diagram illustrating a conventional layout of array blocks and voltage pumping circuits in a semiconductor memory device;
FIG. 2 is a block diagram illustrating a layout of banks, voltage pumping circuits and a control circuit in a semiconductor memory device in accordance with an embodiment of the present invention;
FIG. 3 is a detailed circuit diagram illustrating an embodiment of the control circuit in FIG. 3;
FIG. 4 is a timing diagram illustrating the operation of the control circuit in FIG. 4;
FIG. 5 is a detailed circuit diagram illustrating an alternative embodiment of the control circuit in FIG. 3; and
FIG. 6 is a timing diagram illustrating the operation of the control circuit in FIG. 6.

### Detailed Description of the Preferred Embodiments

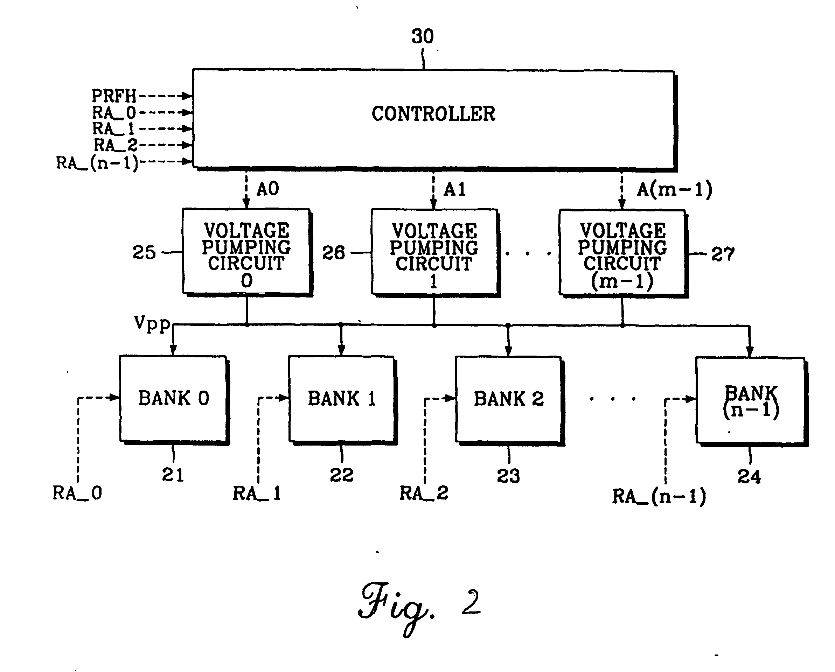

FIG. 2 is a block diagram illustrating a layout of banks, voltage pumping circuits and a control circuit in a semiconductor memory device in accordance with an embodiment of the present invention. As shown in this drawing, a memory cell array is divided into a plurality of banks or n banks 21-24. A desired number of voltage pumping circuits or m voltage pumping circuits 25-27 are connected to the banks 21-24. A control circuit 30 has input terminals for receiving a refresh signal PRFH and row address signals RA_0-RA_(n-1), respectively, and its output terminals connected respectively the input terminals of the voltage pumping circuits 25-27.

In FIG. 2, m voltage pumping circuits are sequentially driven in a bank active mode so that the voltage pumping operation can be secured in each tRRD cycle. For example, in the case where the tRRD cycle is 20ns and the voltage pumping operation cycle is 40ns, the voltage pumping operation can reasonably be performed in the bank active mode by alternately driving two voltage pumping circuits. Provided that the tRRD cycle is short or the voltage pumping operation cycle is long, m voltage pumping circuits are required, where m is a minimum integer larger than the value which is obtained by dividing the voltage pumping operation cycle by the tRRD cycle.

The m voltage pumping circuits are sequentially operated. Therefore, in a semiconductor memory device with many banks, the pumped voltage necessary to the bank operation can be supplied by employing at least m voltage pumping circuits. As a result, the voltage pumping operation can efficiently be performed and the chip size can be reduced.

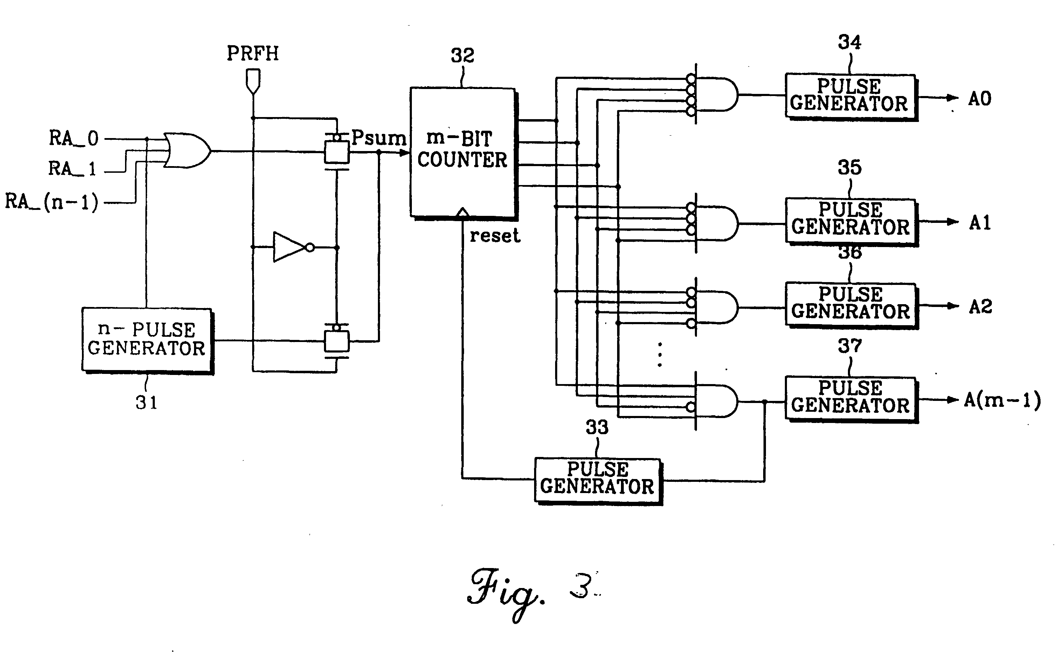

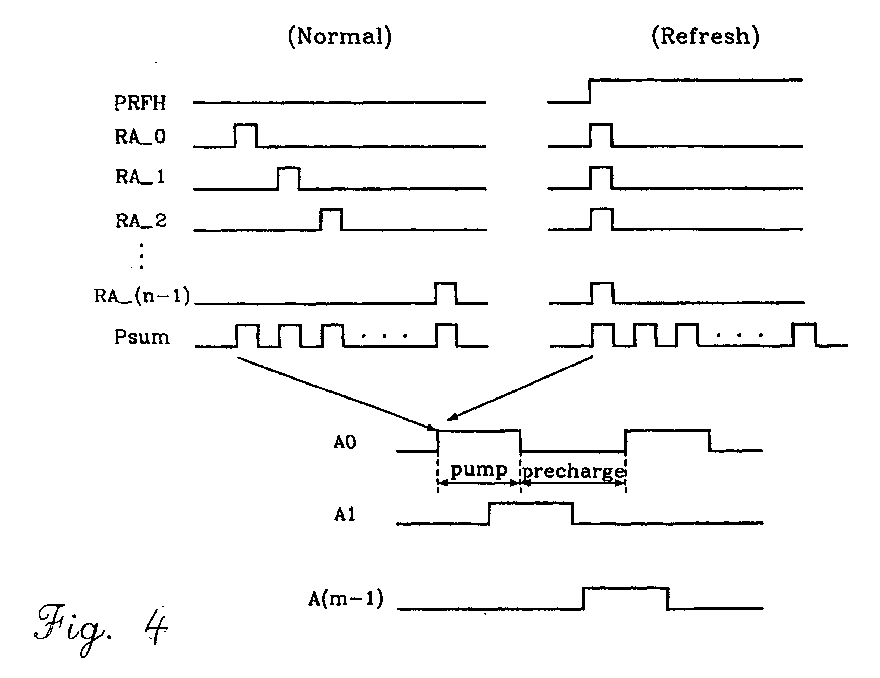

FIG. 3 is a detailed circuit diagram illustrating an embodiment of the control circuit 30 in FIG. 2 and FIG. 4 is a timing diagram illustrating the operation of the control circuit 30 in FIG. 3.

In FIG. 3, the control circuit 30 is constructed to control at least two voltage pumping circuits. The control circuit 30 includes an n-pulse generation circuit 31 which allows the pumping operation to be performed n times in a refresh mode similarly to the normal mode. The output of the n-pulse generation circuit 31 is transferred to an m-bit counter 32 through a transfer gate which is switched in response to the refresh signal PRFH.

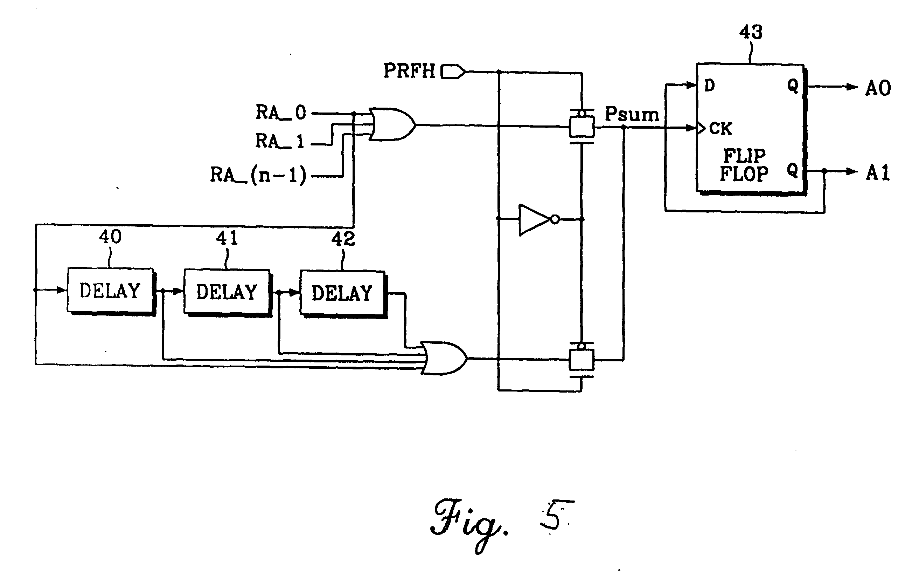

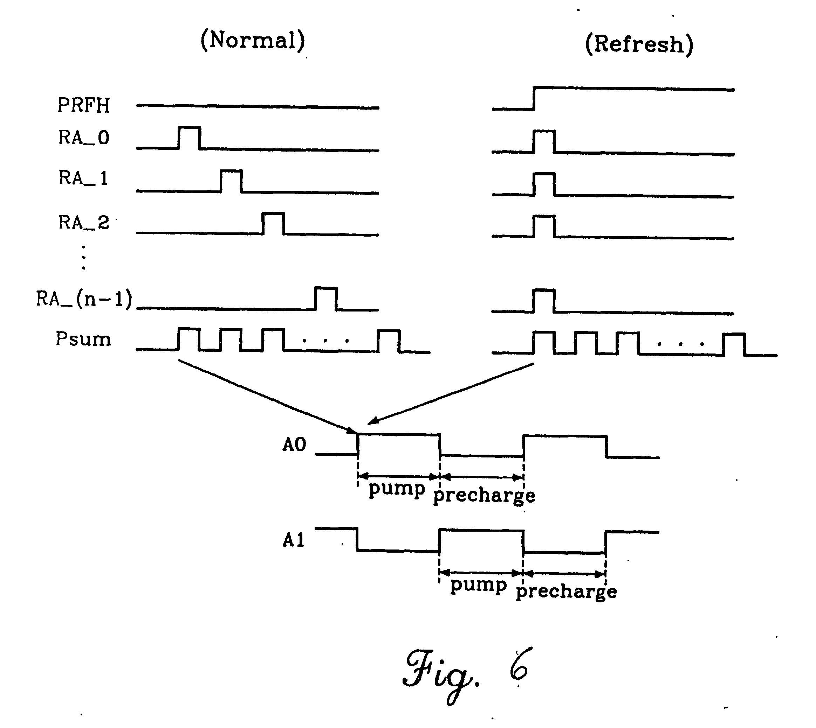

FIG. 5 is a detailed circuit diagram illustrating an alternative embodiment of the control circuit 30 in FIG. 3 and FIG. 6 is a timing diagram illustrating the operation of the control circuit 30 in FIG. 5.

In FIG. 5, the control circuit 30 is constructed to control two voltage pumping circuits (i.e., m = 2). A D-type flip-flop 43 is provided to generate a signal which is triggered synchronously with the positive edge of an input signal. The two voltage pumping circuits are alternately operated in response to the output signal from the D flip-flop 43. In other words, the voltage pumping circuit 1 is precharged when the voltage pumping circuit 0 performs the voltage pumping operation. Also, the voltage pumping circuit 1 performs the voltage pumping operation when the voltage pumping circuit 0 is precharged. An n-pulse generation circuit is required to allow the pumping operation to be performed n times in the refresh mode similarly to the normal mode. The output of the n-pulse generation circuit is transferred to the D-type flip-flop 43 through a transfer gate which is switched in response to the refresh signal PRFH. In FIG. 5, the n-pulse generation circuit is provided with three delay elements 40-42 and one OR gate.

As apparent from the above description, according to the present invention, the voltage pumping circuits are arranged in the semiconductor memory device in a proper manner efficiently to perform the voltage pumping operation, so as to increase the pumping efficiency. Further, the proper arrangement of the voltage pumping circuits contributes to the integration of the semiconductor memory device.

## Claims

1. A semiconductor memory device comprising:
a memory cell array including a number, n, of banks 5 (21-24), where n > 2;
a number, m, of voltage pumping circuits (25-27) each for pumping an input voltage to a desired level (Vpp), where 2 ≤ m < n;
a control circuit (30) adapted to receive address signals (RA) selecting respective banks and, in response, to activate a selected voltage pumping circuit;
**characterised in that** the control circuit is adapted, on receipt of any address signal (RA) selecting any one of the n banks, to activate the next in a predetermined cyclic sequence of the m voltage pumping circuits.

2. A semiconductor memory device according to claim 1 in which m=2.

3. A semiconductor memory device according to claim 1 or claim 2 in which outputs of all of the voltage pumping circuits are electrically connected together, and are further electrically connected to all of the respective inputs of the banks, which inputs are also electrically connected together.

4. A semiconductor memory device according to any preceding claim, in which the control circuit comprises a counter (32) which is incremented each time one of the said banks is selected and means for decoding the count value to provide an activating signal to a respective voltage pumping circuit.

5. A semiconductor memory device according to claim 4 in which the means for decoding the count value comprises a series of logic gates, each of which is adapted to recognize a particular count value and to provide an enabled output signal when the count reaches that particular value.

6. A semiconductor memory device according to claim 5 in which the output of each of the said logic gates is fed to a pulse generator (34-37) to generate the control signal 5 for the respective voltage pumping circuit.

7. A semiconductor memory device according to claim 6 in which the logical sum (Psum) of the bank selection signals is fed to the input of the counter (32) in the normal mode; and the output of a multi-pulse generator (31) which is activated by each of the bank selection signals (RA) is fed to the input of the counter in the refresh mode.

8. A semiconductor memory device according to any one of claims 1-5, in which m=2 and the control circuit comprises a D-type flip-flop (43) connected to receive a CK input (Psum) each time one of the banks is selected, the Q and /Q outputs serving as activating signals for respective voltage pumping circuits.

9. A semiconductor memory device according to claim 8 in which the logical sum (Psum) of the bank selection signals is fed to the CK input of the D-type flip-flop in the normal mode and the output of a multi-pulse generator which is activated by each of the bank selection signals (RA) is fed to the CK input of the D-type flip-flop in the refresh mode.

10. A semiconductor memory device according to any preceding claim, which is a semiconductor DRAM.

11. A method of operating a semiconductor memory device comprising a memory cell array including a number, n, of banks (21-24), where n > 2 and a number, m, of voltage pumping circuits (25-27) each for pumping an input voltage to a desired level (Vpp), where 2 ≤ m < n, the method comprising:
receiving address signals (RA) selecting respective banks and, in response, activating a selected voltage pumping circuit;
**characterised in that**, on receipt of any address signal (RA) selecting any one of the n banks, the next in a predetermined cyclic sequence of the m voltage pumping circuits is activated.

12. A method according to claim 11 in which the semiconductor memory device is as claimed in any one of claims 1-9.

## Patentansprüche

1. Halbleiterspeicheranordnung, umfassend:
ein Speicherzellen-Feld, enthaltend eine Anzahl, n, von Bänken (21-24), wobei n > 2;
eine Anzahl, m, von Spannungspumpenschaltungen (25-27), jeweils zum Erhöhen einer Eingangsspannung auf ein gewünschtes Level (Vpp), wobei 2 ≤ m < n;
eine Steuerschaltung (30) die ausgebildet ist zum Empfangen von Adress-Signalen (RA), welche jeweilige Bänke auswählen, und, als Antwort, zum Aktivieren einer ausgewählten Spannungspumpenschaltung;
**dadurch gekennzeichnet, dass** die Steuerschaltung ausgebildet ist, auf Empfang irgendeines Adress-Signals (RA) hin, welches irgendeine der n Bänke auswählt, die nächste in einer vorbestimmten zyklischen Folge der m Spannungspumpenschaltungen zu aktivieren.

2. Halbleiterspeicheranordnung nach Anspruch 1, bei der m = 2.

3. Halbleiterspeicheranordnung nach Anspruch 1 oder 2, in welcher Ausgänge aller Spannungspumpenschaltungen elektrisch miteinander verbunden sind und weiterhin elektrisch mit allen jeweiligen Eingängen der Bänke verbunden sind, wobei diese Eingänge ebenfalls elektrisch miteinander verbunden sind.

4. Halbleiterspeicheranordnung nach einem der vorstehenden Ansprüche, bei dem die Steuerschaltung einen Zähler (32), der immer dann inkrementiert wird, wenn eine der Bänke ausgewählt wird, und Mittel zum Dekodieren des Zählwertes zum Bereitstellen eines Aktivierungssignals für eine jeweilige Spannungspumpenschaltung umfasst.

5. Halbleiterspeicheranordnung nach Anspruch 4, bei der die Mittel zum Dekodieren des Zählwertes eine Reihe von Logik-Gattern umfassten, von denen jedes ausgebildet ist, einen bestimmten Zählwert zu erkennen und ein Freigabe-Ausgangssignal bereit zu stellen, wenn der Zählwert einen bestimmten Wert erreicht.

6. Halbleiterspeicheranordnung nach Anspruch 5, bei der der Ausgang jedes der Logik-Gatter auf einen Pulsgenerator (34-37) geführt ist, zum Erzeugen des Steuersignals für die jeweilige Spannungspumpenschaltung.

7. Halbleiterspeicheranordnung nach Anspruch 6, bei der die logische Summe (Psum) der Bankauswahlsignale im normalen Modus auf den Eingang des Zählers (32) geführt ist, und bei dem der Ausgang eines Multipulsgenerators (31), der durch jedes der Bankauswahl-Signale (RA) aktiviert wird, im Auffrischungsmodus auf den Eingang des Zählers geführt ist.

8. Halbleiterspeicheranordnung nach einem der Ansprüche 1 bis 5, bei dem m = 2 und bei dem die Steuerschaltung einen Flip-Flop (43) vom D-Typ umfasst, der verbunden ist, ein CK-Eingangssignal (Psum) immer dann zu empfangen, wenn eine der Bänke ausgewählt ist, wobei die Q- und /Q-Ausgänge als Aktivierungssignale für jeweilige Spannungspumpenschaltungen dienen.

9. Halbleiterspeicheranordnung nach Anspruch 8, bei der die logische Summe (Psum) der Bank-Auswahlsignale im normalen Modus auf den CK-Eingang des D-Typ Flip-Flops geführt ist und der Ausgang eines Multipulsgenerators, der von jedem der Bank-Auswahlsignale (RA) aktiviert wird, im Auffrischungsmodus auf den CK-Eingang des D-Typ Flip-Flops geführt ist.

10. Halbleiterspeicheranordnung nach einem der vorstehenden Ansprüche, die ein Halbleiter-DRAM ist.

11. Verfahren zum Betreiben einer Halbleiterspeicheranordnung umfassend ein Speicherzellen-Feld, enthaltend eine Anzahl, n, von Bänken (21-24), wobei n > 2, eine Anzahl, m, Spannungspumpenschaltungen (25-27), jeweils zum Erhöhen einer Eingangsspannung auf ein gewünschtes Level (Vpp), wobei 2 ≤ m < n, wobei die Methode umfasst:
Empfangen von Adress-Signalen (RA), welche jeweilige Bänke auswählen, und, als Antwort, Aktivieren einer ausgewählten Spannungspumpenschaltung,
**dadurch gekennzeichnet, dass** auf den Empfang irgendeines Adresssignals (RA) hin, welches irgendeine der n Bänke auswählt, die nächste Spannungspumpenschaltung in einer vorbestimmten zyklischen Folge der m Spannungspumpenschaltungen aktiviert wird.

12. Verfahren nach Anspruch 11, bei dem die Halbleiterspeicheranordnung wie in einem der Ansprüche 1 bis 9 ausgebildet ist.

## Revendications

1. Dispositif de mémoire à semiconducteurs, comprenant :
un groupement de cellules de mémoire comportant un nombre, n, de bancs (21 à 24), où n > 2 ;
un nombre, m, de circuits de pompage de tension (25 à 27), servant chacun à pomper une tension d'entrée à un niveau désiré (Vpp), où 2 ≤ m < n ;
un circuit de commande (30) adapté pour recevoir des signaux d'adresse (RA) sélectionnant des bancs respectifs, et, en réponse, pour activer un circuit de pompage de tension sélectionné,
**caractérisé en ce que** le circuit de commande est adapté, lors de la réception d'un quelconque signal d'adresse (RA) sélectionnant l'un quelconque des n bancs, pour activer le suivant dans une séquence cyclique prédéterminée des m circuits de pompage de tension.

2. Dispositif de mémoire à semiconducteurs selon la revendication 1, dans lequel m = 2.

3. Dispositif de mémoire à semiconducteurs selon la revendication 1 ou la revendication 2, dans lequel des sorties de tous les circuits de pompage de tension sont électriquement connectées les unes aux autres, et sont de plus électriquement connectées à toutes les entrées respectives des bancs, ces entrées étant également électriquement connectées les unes aux autres.

4. Dispositif de mémoire à semiconducteurs selon l'une quelconque des revendications précédentes, dans lequel le circuit de commande comprend un compteur (32) qui est incrémenté à chaque fois que l'un desdits bancs est sélectionné et des moyens pour décoder la valeur de pompage de façon à délivrer un signal d'activation à un circuit de pompage de tension respectif.

5. Dispositif de mémoire à semiconducteurs selon la revendication 4, dans lequel les moyens pour décoder la valeur de comptage comprennent une série de portes logiques, chacune d'entre elles étant adaptée pour reconnaître une valeur de comptage particulière et pour délivrer un signal de sortie validé lorsque le comptage atteint cette valeur particulière.

6. Dispositif de mémoire à semiconducteurs selon la revendication 5, dans lequel la sortie de chacune desdites portes logiques est délivrée à un générateur d'impulsions (34 à 37) pour générer le signal de commande pour le circuit de pompage de tension respectif.

7. Dispositif de mémoire à semiconducteurs selon la revendication 6, dans lequel la somme logique (Psum) des signaux de sélection de banc est délivrée à l'entrée du compteur (32) dans le mode normal ; et la sortie d'un générateur d'impulsions multiples (31) qui est activé par chacun des signaux de sélection de banc (RA) est délivrée à l'entrée du compteur dans le mode de rafraîchissement.

8. Dispositif de mémoire à semiconducteurs selon l'une quelconque des revendications 1 à 5, dans lequel m = 2 et le circuit de commande comprend une bascule du type D (43) connectée pour recevoir une entrée d'horloge (Psum) à chaque fois que l'un des bancs est sélectionné, les sorties Q et /Q jouant le rôle de signaux d'activation pour des circuits de pompage de tension respectifs.

9. Dispositif de mémoire à semiconducteurs selon la revendication 8, dans lequel la somme logique (Psum) des signaux de sélection de banc est délivrée à l'entrée d'horloge de la bascule du type D dans le mode normal, et la sortie d'un générateur d'impulsions multiples qui est activé par chacun des signaux de sélection de banc (RA) est délivrée à l'entrée d'horloge de la bascule du type D dans le mode de rafraîchissement.

10. Dispositif de mémoire à semiconducteurs selon l'une quelconque des revendications précédentes, qui est une mémoire vive dynamique (DRAM) à semiconducteurs.

11. Procédé d'utilisation d'un dispositif de mémoire à semiconducteurs comprenant un groupement de cellules de mémoire comprenant un nombre, n, de bancs (21 à 24), où n > 2, et un nombre, m, de circuits de pompage de tension (25 à 27), servant chacun à pomper une tension d'entrée à un niveau désiré (Vpp), où 2 ≤ m < n, le procédé comprenant :
la réception de signaux d'adresse (RA) sélectionnant des bancs respectifs, et activant en réponse un circuit de pompage de tension sélectionné,
**caractérisé en ce que**, lors de la réception d'un quelconque signal d'adresse (RA) sélectionnant un quelconque des n bancs, le suivant dans une séquence cyclique prédéterminée des m circuits de pompage de tension est activé.

12. Procédé selon la revendication 11, dans lequel le dispositif de mémoire à semiconducteurs est selon l'une quelconque des revendications 1 à 9.
